(19) Europäisches Patentamt / European Patent Office / Office européen des brevets

(11) **EP 2 101 119 A1**

(12) **EUROPEAN PATENT APPLICATION**

(43) Date of publication:
**16.09.2009 Bulletin 2009/38**

(51) Int Cl.:
*F24F 5/00* (2006.01)     *E04D 3/35* (2006.01)
*F24J 2/14* (2006.01)     *F24J 2/04* (2006.01)
*F24J 2/26* (2006.01)     *F25B 23/00* (2006.01)

(21) Application number: **08102502.5**

(22) Date of filing: **11.03.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicant: **Helianthos B.V.**
**6824 BM Arnhem (NL)**

(72) Inventors:
• **Kristinsson, Jon**
 **7411 SE, Deventer (NL)**
• **Dubbeldam, Gerrit Cornelis**
 **6904 PH, Zevenaar (NL)**

(74) Representative: **Zonneveld, Hendrik Jan et al**
 **De Vries & Metman**
 **Overschiestraat 180**
 **1062 XK Amsterdam (NL)**

(54) **Roof element**

(57) Roof element comprising a metal base (4) with one side coated with a transparent polymeric coating (5) and the opposite side comprising a contact surface for a cooling medium flow path (6). Coolant, e.g., water, can be guided along the contact surface and cooled, for instance at night. Heat from the coolant medium is dissipated and radiated by the roof element. The cooled coolant is subsequently transported to a storage, such as an aquifer.

FIG. 2

**Description**

The invention relates to a roof element particularly useful for heat dissipation by radiation. Such roofs elements are typically used to dissipate heat from a coolant medium such as water in a cooling system or climate control system.

A roof structure comprising a sheet metal cover plate used for collecting solar energy and for radiating unwanted heat is disclosed in US 4,098,260. The roof element has a lower surface in contact with air to be cooled or heated.

US 5,153,780 discloses a sunlight concentrator for a solar cell, made of a metallic base layer coated with a polymeric film.

It is an object of the invention to provide a heat radiating roof element with improved heat dissipation, which is particularly useful for cooling water or a similar coolant medium in a cooling or climate control system.

The object of the invention has been achieved by a roof element comprising a metal base with one side coated with a transparent polymeric coating and the opposite side comprising a contact surface for a cooling medium flow path. Transparent polymeric coatings are transparent for daylight but opaque for infrared. As a result, the heat radiation capacity of the metal base is significantly improved by the polymeric coating.

The coating can for example be based on acrylic binders, polyester binders, polyurethane binders or any other suitable type of polymeric binder. The coating can be based on more than one type of binder. Particularly suitable are hydrophobic binders, such as fluor-polymeric binders, polysilane or polysiloxane binders. A particularly suitable example of a fluoropolymer is (ethylene-tetrafluoroethylene) fluoropolymer (ETFE). The coating can for example be applied as a powder coating, solvent-borne coating, water-borne coating or hot melt coating. Suitable examples of commercially available coatings are for instance Lumiflon® 200 and Tefzel®.

To enhance the self-cleaning effect of the coating, the coating can be provided with transparent nano-particles of a photocatalytic material, such as titanium dioxide.

The coated metal base has light reflective properties and functions as a mirror for visible light. Due to the top coat, it acts as an effective black body for infrared radiation, for instance for wavelengths of about 10 micrometer, which corresponds to a temperature of about 300 K.

The metal base can for instance be a metal plate or sheet or foil or a metal coating on a carrier material, such as wood or a plastic.

The cooling medium flow path can be defined by channels, such as metal tubes, e.g. of copper or a copper alloy having high thermal conductivity.

The mirror properties create the possibility to use the roof element to reflect daylight to a photovoltaic device or solar cell. To improve the reflectivity of the metal base, the metal base can at least partly be made of a metal with a reflectivity R > 0.5, such as aluminum or an aluminum alloy. To maximize reflectivity, the mental can for instance be a polished metal. The metal can for instanced be polished chemically. A metal foil, e.g., an aluminum foil, can be used attached on a carrier body, for instance of wood, pressed wood, steel or concrete.

Typically, the absorption by transparent polymeric coatings in the visible part of the spectrum is low, while the absorption in the infrared part of the spectrum is substantially higher. It has been found that the absorption by aluminum coated with Tefzel® is essentially of the same level as the absorption by bare aluminum in the visible part of the spectrum. However, at wavelengths above about 5 microns, the absorption by Tefzel® coated aluminum is much higher than the absorption by bare aluminum.

In terms of thermal radiation, the emission coefficient corresponds to the level of absorption. It has been found that the emission coefficient of Tefzel® $\varepsilon > 0.8$ for wavelengths between 5 and 15 microns. When the emission coefficient of a surface is independent of the wavelength it is called a grey surface. A grey surface emits radiation energy according to the equation:

$$W_{emitted} = \varepsilon * \sigma * T_{surface}^4$$

with $\sigma$ being the so-called Stefan-Boltzmann constant ($\approx 5.7 \times 10^{-8}$ W.m$^{-2}$K$^{-4}$) and $T_{surface}$ the absolute surface temperature (K).

The surface also absorbs irradiated radiation depending on the absolute temperature of the surrounding $T_{surrounding}$ (K):

$$W_{absorbed} = \varepsilon * \sigma * T_{surrounding}^4$$

The net energy emission is:

$$W_{emitted} - W_{absorbed} = \varepsilon * \sigma * (T_{surface}^4 - T_{surrounding}^4)$$

When the temperature of a flat surface is 40°C (313K) and the radiation temperature of the surrounding is 10°C (283K) the net energy emission is > 0.8 x 5.7 x $10^{-8}$ ($313^4$ - $283^4$) $\approx$ 150 W.m$^{-2}$. For comparison: the total irradiated sunlight at noon with a clear sky is about + 1000 W.m$^{-2}$.

The emission coefficient $\varepsilon$ of bare aluminium is about s = 0.01. When the temperature of a flat surface $T_{surface}$ is 40°C (313K) and the surrounding radiation temperature $T_{surrounding}$ is 10°C (283K) the net energy emission is only 0.01 x 5.7 x $10^{-8}$ ($313^4$ - $283^4$) $\approx$ 1.8 W.m$^{-2}$.

To increase the amount of sunlight reflected to the photovoltaic device, the roof element can be curved to create a concentrating effect. For instance, the roof element can have a parabolic cross section. Such a roof element can comprise a photovoltaic device located on the focal line of the parabolic shape. The photovoltaic device can for instance be a carrier plate sandwiched between two photovoltaic foils. A particularly suitable photovoltaic foil is for instance disclosed in WO 98 / 013882.

The parabolic outline can be slightly deformed or broken in order to form a focus line equally distributing the concentrated sun light over the width of the photovoltaic element.

The photovoltaic element can comprise water channels to cool the element. The heated cooling water can be recycled or used for further purposes.

When radiating heat, moisture in the ambient air will condense on the roof element in liquid or frozen form. The amount of condense water is dependent on the humidity of the air and the difference between the radiation temperature of the roof element and the radiation temperature of the sky. A clear night will typically result in more condense water. The condense water can be collected for further use. To this end the roof element can be placed under an angle and/or it can be made in the form of a gutter or trough.

The roof element can for instance be a longitudinal parabolic gutter or trough. This way roof element forms a channel, e.g., for condense water and/or rain water. A number of these parabolic gutters can be used to form a roof, for instance arranged adjacently. The gutters can be positioned under an angle with the horizon, in order to discharge the collected water, e.g., to a storage tank.

The cooling medium flow path can for instance form part of a cooling system of a building, wherein the cooled medium is stored in an isolated basin, such as an aquifer. When the temperature rises, e.g., on a hot weather day, the cool water can be returned to the building to cool the building. The water cools the interior of the building by absorbing heat. At night, the used water is guided along the interior surface of the roof element which absorbs heat from the water and radiates it into the night. The cooled water is then returned to the basin for storage.

Optionally, the roof element can also be used to collect heat, e.g., to heat water or another medium. Heated water can also be stored in an aquifer or other type of heat storage basin. This way, the roof element can be used to heat water at day time while at night the roof element is used to cool water so the cooled water can be used at day time to cool the building.

In an aquifer, water of different temperatures can be stored in different layers or stratifications. For instance hot water can be stored as a free-floating layer on the surface of a body of cold water. Further means can be used for controlling thermal and hydraulic gradients in an aquifer storage area, and for thermally and hydraulically isolating the storage area. These include means comprising interposed plastic or insulating layers for reducing the heat loss at and near the ground surface; means for preventing percolation of water into the storage areas; barriers for artificially confining the stored volume of water in certain areas of the storage system, and for controlling the horizontal flow in different strata of the aquifer systems. Unacceptably high hydraulic gradients can be neutralized by pumping or siphoning water into or out of the area from other sources. Further, a lens of cold fresh water can be used supported and confined for storage in a body of salt water. Salt water seepage into the aquifer system may be controlled by utilizing an injected layer of clay or other means for forming a water-impervious layer to confine the volume of water.

The invention will now be described in more detail, by way of example only, with reference to the accompanying drawing, wherein:

Figure 1:  shows in perspective view a building with a roof formed by roof elements according to the present invention;
Figure 2:  shows in cross section a roof element of the roof of Figure 1;
Figure 3:  shows in cross section a photovoltaic cell of the roof element of Figure 2.

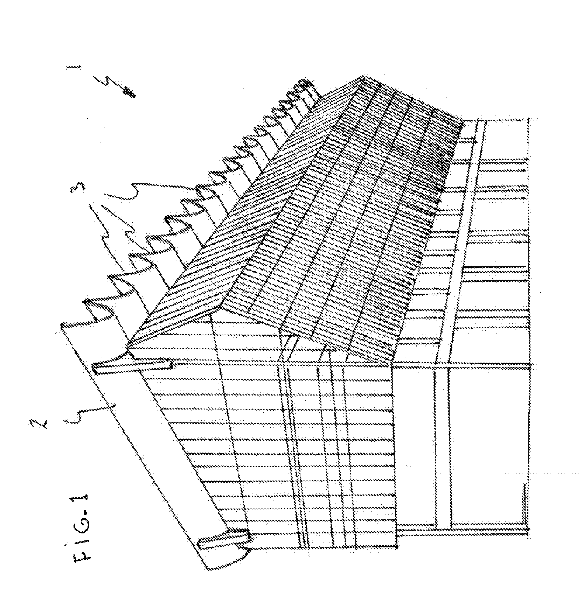

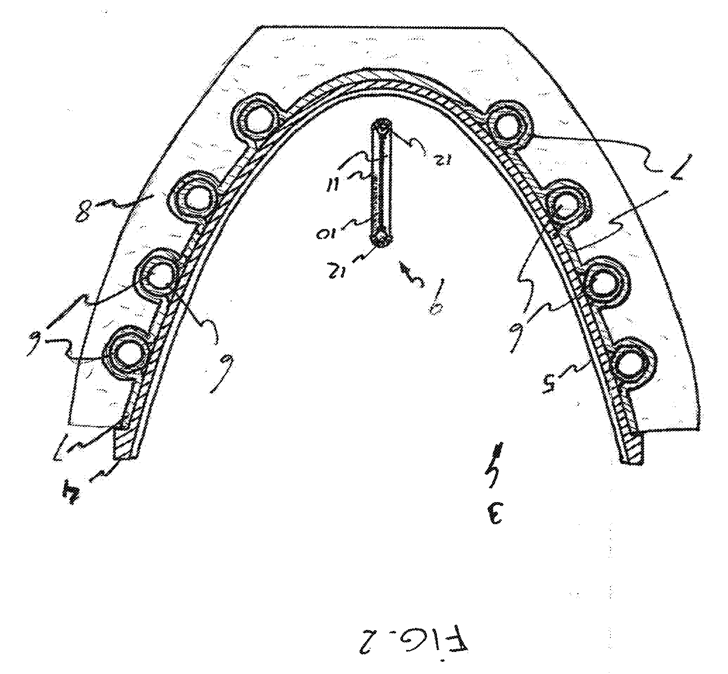

Figure 1 shows a building 1 with a roof 2 made of a large number of parallel roof elements 3 with a parabolic cross section, as shown in more detail in Figure 2.

The parabolic roof element 3 comprises a metal base 4, e.g. of polished, highly reflective aluminum. On its interior side, the metal base 4 is provided with a transparent top coat 5. On its concave exterior side the aluminum base plate 4 borders a flow path for a cooling medium, such as water, defined by tubes 6 of a copper alloy. The tubes 6 are fixed to the aluminum parabolic shell 4 by a foil 7 shrunk around the tubes 6 and adhering to the aluminum shell 4. The tubes 6 and the foil 7 are embedded in a layer 8 of a building material, e.g. a heat insulating material such as pressed wood.

The tubes 6 form part of a cooling medium circulation system. When water passes the tubes 6, heat is dissipated to the aluminum shell 4 and radiated via the coating layer 5. The cooled water follows its way to a storage basin, such as an underground aquifer. When the temperature rises, e.g., on a hot day, the cool water can be returned from the aquifer to the building. The water cools the interior of the building by absorbing heat. At night, the used water is guided along the tubes 6 of the roof element 3 which absorbs heat from the water and radiates it into the night. The cooled water is then returned to the basin for storage.

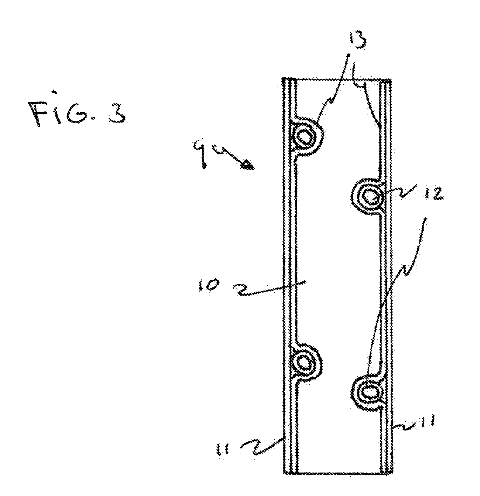

Centrally disposed within the roof element 3 on the focal line of the parabolic cross section is a photovoltaic cell or solar cell 9, shown in more detail in Figure 3. The photovoltaic cell 9 comprises a carrier plate 10 sandwiched by two photovoltaic foils 11. At the edges, the cell 9 comprises channels 12 for cooling water to prevent overheating of the cell 9, e.g., to keep it below 80 °C. Daylight is reflected by the polished aluminum shell 4. The reflected light is concentrated to the focal line of the parabolic roof element 3 where the photovoltaic cell 9 is located. Due to this arrangement a maximized quantity of solar energy is absorbed by the photovoltaic cell and transformed to electricity.

Figure 3 shows the photovoltaic cell 9 in cross section showing the photovoltaic foils 11 adhered by adhesive layer 13 to a carrier plate 10. Cooling channels 12 of a high thermal conductivity pass the photovoltaic foils 11 along their surface attached to carrier block 10.

**Claims**

1. Roof element comprising a metal base with one side coated with a transparent polymeric coating and the opposite side comprising a contact surface for a cooling medium flow path.

2. Roof element according to claim 1 **characterized in that** the metal base is a polished metal.

3. Roof element according to claim 1 or 2 **characterized in that** the metal base is at least partly made of aluminum.

4. Roof element according to any one of the preceding claims **characterized in that** the coating comprises a fluor polymer binder.

5. Roof element according to anyone of the preceding claims **characterized in that** it has a parabolic cross section.

6. Roof element according to claim 5 **characterized in that** a photovoltaic device is located on the focal line of the parabolic shape.

7. Roof element according to any one of the preceding claims **characterized in that** the lower surface confines a flow path channel for a liquid cooling medium, e.g., cooling water.

8. Method for collecting a cooled liquid coolant, such as water **characterized in that** the coolant is guided along a roof element comprising a metal base with one side coated with a transparent polymeric coating and the opposite side comprising a contact surface for the coolant and **in that** the cooled coolant is subsequently transported to a storage, such as an aquifer.

9. Method according to claim 8 **characterized in that** at day time water is guided along the roof element to collect heat while at night water is guided along the roof element to cool, and **in that** the water cooled at night and the water heated at day time are stored in different stratification in an aquifer.

10. Method for collecting condense water from ambient air **characterized in that** condensation is initiated by heat radiation by a roof element according to any one of the preceding claims 1 - 7.

FIG. 1

FIG. 2

FIG. 3

**European Patent Office**

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2007/008578 A (PARISE RONALD J [US]) 18 January 2007 (2007-01-18) * abstract * * paragraphs [0039], [0044] * * figures 23-30,32,34 * | 1-4 | INV. F24F5/00 E04D3/35 ADD. F24J2/14 |
| X | US 4 617 717 A (YAMAMOTO HIDEOMI [JP] ET AL) 21 October 1986 (1986-10-21) * figure 1 * | 1,8 | F24J2/04 F24J2/26 F25B23/00 |
| X | US 3 866 285 A (CLARK HAROLD A) 18 February 1975 (1975-02-18) * figure 4 * * column 3, line 44 - column 4, line 17 * | 1-3,5-7 | |
| X | US 3 318 107 A (RILEY JOHN E ET AL) 9 May 1967 (1967-05-09) * figures 1-5 * * column 1, line 11 - line 13 * * column 4, line 61 - line 70 * * column 6, line 41 - line 45 * | 1,7,8 9 | |
| Y | | | TECHNICAL FIELDS SEARCHED (IPC) |
| X | US 4 197 993 A (MICHEL JACQUES [FR] ET AL) 15 April 1980 (1980-04-15) * figure 9 * * column 4, line 7 - line 10 * | 1,3 | F25B F24J E04D |
| X | US 4 136 673 A (ESCHER WILLIAM J D) 30 January 1979 (1979-01-30) * figures 1-4 * * column 6, line 16 - line 27 * | 1-3,5,7 | |
| X | US 4 323 619 A (SILVESTRINI VITTORIO ET AL) 6 April 1982 (1982-04-06) * figure 1 * * column 5, line 23 - line 35 * | 1-4 | |

-/--

The present search report has been drawn up for all claims

| Place of search | Date of completion of the search | Examiner |
|---|---|---|
| The Hague | 28 August 2008 | Dezso, Gabor |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

**EUROPEAN SEARCH REPORT**

Application Number

EP 08 10 2502

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 3 043 112 A (HEAD ALAN K) 10 July 1962 (1962-07-10) * figures 1-3 * * column 2, line 8 - line 19 * * column 2, line 28 - line 29 * ----- | 1-3 | |
| X | JP 54 139150 A (SHIN MEIWA IND CO LTD) 29 October 1979 (1979-10-29) * abstract * * figures 1-4 * ----- | 1 | |
| Y | US 4 488 540 A (MCALISTER ROY E [US]) 18 December 1984 (1984-12-18) * figure 2 * ----- | 9 | |
| A | US 4 624 113 A (HULL JOHN R [US] ET AL) 25 November 1986 (1986-11-25) * figures 1-3 * ----- | 1,5,7 | |

TECHNICAL FIELDS SEARCHED    (IPC)

The present search report has been drawn up for all claims

| Place of search | Date of completion of the search | Examiner |
|---|---|---|
| The Hague | 28 August 2008 | Dezso, Gabor |

EPO FORM 1503 03.82 (P04C01)

## ANNEX TO THE EUROPEAN SEARCH REPORT
## ON EUROPEAN PATENT APPLICATION NO.

EP 08 10 2502

This annex lists the patent family members relating to the patent documents cited in the above-mentioned European search report.
The members are as contained in the European Patent Office EDP file on
The European Patent Office is in no way liable for these particulars which are merely given for the purpose of information.

28-08-2008

| Patent document cited in search report | | Publication date | Patent family member(s) | | Publication date |
|---|---|---|---|---|---|
| WO 2007008578 | A | 18-01-2007 | NONE | | |
| US 4617717 | A | 21-10-1986 | GB | 2095715 A | 06-10-1982 |
| | | | JP | 1683802 C | 31-07-1992 |
| | | | JP | 3041336 B | 21-06-1991 |
| | | | JP | 57163557 A | 07-10-1982 |
| | | | US | 4394412 A | 19-07-1983 |
| US 3866285 | A | 18-02-1975 | AT | 352476 B | 25-09-1979 |
| | | | AU | 7639774 A | 17-06-1976 |
| | | | BE | 826073 A1 | 27-08-1975 |
| | | | BR | 7501208 A | 02-12-1975 |
| | | | CA | 991040 A1 | 15-06-1976 |
| | | | DE | 2505522 A1 | 04-09-1975 |
| | | | FR | 2262584 A1 | 26-09-1975 |
| | | | GB | 1500533 A | 08-02-1978 |
| | | | IL | 46558 A | 30-11-1977 |
| | | | IT | 1028183 B | 30-01-1979 |
| | | | JP | 963853 C | 20-07-1979 |
| | | | JP | 50120026 A | 19-09-1975 |
| | | | JP | 53045010 B | 04-12-1978 |
| | | | ZA | 7500735 A | 28-01-1976 |
| US 3318107 | A | 09-05-1967 | NONE | | |
| US 4197993 | A | 15-04-1980 | NONE | | |
| US 4136673 | A | 30-01-1979 | NONE | | |
| US 4323619 | A | 06-04-1982 | AU | 514902 B2 | 05-03-1981 |
| | | | AU | 3249078 A | 26-07-1979 |
| | | | BR | 7800244 A | 05-09-1978 |
| | | | DE | 2801665 A1 | 20-07-1978 |
| | | | EG | 13011 A | 31-03-1980 |
| | | | FR | 2377646 A1 | 11-08-1978 |
| | | | GB | 1598017 A | 16-09-1981 |
| | | | IL | 53828 A | 16-09-1980 |
| | | | IT | 1076556 B | 27-04-1985 |
| | | | JP | 53114885 A | 06-10-1978 |
| | | | MX | 150755 A | 12-07-1984 |
| US 3043112 | A | 10-07-1962 | NONE | | |
| JP 54139150 | A | 29-10-1979 | JP | 1211278 C | 12-06-1984 |
| | | | JP | 58044959 B | 06-10-1983 |

EPO FORM P0459

For more details about this annex : see Official Journal of the European Patent Office, No. 12/82

## ANNEX TO THE EUROPEAN SEARCH REPORT
## ON EUROPEAN PATENT APPLICATION NO.

EP 08 10 2502

This annex lists the patent family members relating to the patent documents cited in the above-mentioned European search report.
The members are as contained in the European Patent Office EDP file on
The European Patent Office is in no way liable for these particulars which are merely given for the purpose of information.

28-08-2008

| Patent document cited in search report | | Publication date | Patent family member(s) | Publication date |
|---|---|---|---|---|
| US 4488540 | A | 18-12-1984 | NONE | |
| US 4624113 | A | 25-11-1986 | NONE | |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4098260 A
- US 5153780 A